# EUROPEAN PATENT APPLICATION

(11) **EP 2 407 792 A1**
(43) Date of publication of application: **18.01.2012**
(21) Application number: 11171997.7
(22) Date of filing: 29.06.2011
(51) Int. Cl.: G01R 15/24

(54) **Fiber current sensor with reduced temperature sensitivity**

(30) Priority: 12.07.2010 US 834150
(71) Applicant: Honeywell International, Inc., Morristown, New Jersey 07962-2245 (US)
(72) Inventor: Sanders, Glen A., Morristown, NJ New Jersey 07962-2245 (US)
(74) Representative: Buckley, Guy Julian

(57) **Abstract**

A sensor head assembly (124) is provided, comprising a quarter wave device (120) having shape-induced-birefringence and a sensing coil (126) coupled to the quarter wave device and operable to wind around a current conductor (140). The quarter wave device converts linearly polarized light from a polarization maintaining fiber to circularly polarized light.

## Description

### BACKGROUND

Optical current sensors detect electrical current and commonly employ fiber optic quarter wave devices with stress birefringence. Stress induced birefringence is largely temperature dependent, as stress varies unevenly between two principal axes of the quarter wave device, causing change in the differing indices of refraction over temperature. Current sensors can be exposed to a wide temperature range, for example, those used in outdoor current transformers in the high voltage power industry. The temperature sensitivity of the typical fiber optic current sensors adversely affects their accuracy over such temperature ranges.

### SUMMARY

Some embodiments described herein provides a sensor head assembly that comprises a quarter wave device having shape-induced-birefringence and a sensing coil coupled to the quarter wave device and operable to wind around a current conductor. The quarter wave device converts linearly polarized light from a polarization maintaining fiber to circularly polarized light.

### DRAWINGS

Understanding that the drawings depict only exemplary embodiments and are not therefore to be considered limiting in scope, the exemplary embodiments will be described with additional specificity and detail through the use of the accompanying drawings, in which:

Figure 1A is a block diagram of one embodiment of a fiber optic current sensor.

Figure 1B is a schematic diagram of an embodiment of a single phase high voltage current measuring system.

Figure 2 is a diagram of one embodiment of a shape-induced-birefringence fiber.

Figure 3 is an exemplary embodiment of a shape-induced-birefringence fiber with its polarization axes rotated at 45 degrees to a polarization axis of a polarization maintaining fiber.

Figure 4 is a flowchart of one embodiment of a method of sensing current using a current sensor with a shape-induced-birefringence fiber.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

Embodiments described herein provide a length of shape-induced-birefringence fiber to induce a quarter wave phase shift between two linear states of polarization to create circularly polarized light. Quarter wave devices comprising photonic crystal fiber using shape-induced-birefringence decrease temperature dependence in current sensors. This improves the current sensor's accuracy over temperature ranges.

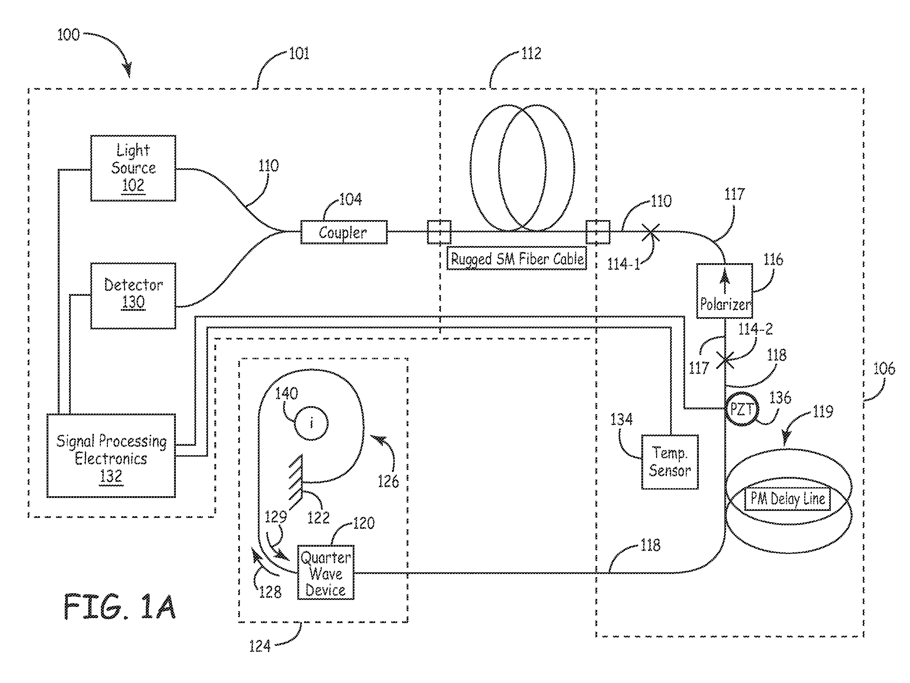

Figure 1A is a block diagram of one embodiment of a fiber optic current sensor 100. The fiber optic current sensor 100 determines the value of the current flowing through a current conductor 140. The fiber optic current sensor 100 comprises electronics and optics assembly 101 providing a first end of an optical path, a cable assembly 112, polarizing and modulation assembly 106, and a sense head assembly 124 providing a second end of the optical path. Non-polarized light generated by the electronics and optics assembly 101 travels through the cable assembly 112 to the polarizing and modulation assembly 106. The light is split into two linearly polarized waves in the polarizing and modulation assembly 106 and is provided to the sense head assembly 124. At the sense head assembly 124, the two linearly polarized waves are converted to two circularly polarized light waves, which sustain a relative phase shift between them from exposure due to a magnetic field from current in the current conductor 140, and travels back through the system 100 to the electronics and optics assembly 101 where the phase shift in the light is resolved into a measure of the current flowing in the current conductor 140.

The electronics and optics assembly 101 comprises a light source 102, a coupler 104, a detector 130, and signal processing circuitry 132. The light source 102 provides light to an optical fiber 110 that passes through the coupler 104. The coupler 104 is a beam splitter that passes light traveling from the light source 102 and directs light coming from the sense head assembly 124 to the detector 130. The light travels through the cable assembly 112 and then into the polarizing and modulation assembly 106. The polarizing and modulation assembly 106 also includes a temperature sensor 134 to measure the temperature (for example, an outdoor temperature), which is used for real-time thermal compensation of the current sensor output in some embodiments. In another embodiment, the electronics and optics assembly 101 is enclosed in a protective covering, building, or the like.

In the polarizing and modulation assembly 106, the light passes through a splice 114-1. In one embodiment, the splice 114-1 is a connector. The splice 114-1 joins the fiber 110 to the polarizer input fiber 117 which directs light towards the polarizer 116. A polarizer 116 linearly polarizes the light. The polarizer is coupled to two strands of polarization maintaining fibers 117 at its input and output, each of which has one of its principal axes oriented to the pass-axis of the polarizer 116. In this case, the polarizer output fiber 117 is spliced at 114-2 to a polarization maintaining (PM) fiber 118 at a 45 degree angle of incidence, creating two co-propagating linearly polarized waves of nominally equal amplitude passing through PM fiber 118. In one embodiment, the light changes from a non-polarized state to a linear polarization upon passing through the polarizer 116. In another embodiment, the light source 102 emits linearly polarized light and splice 114-1 is replaced with a short length of polarization maintaining fiber, with an approximately 45 degree splice to the fiber 117 so as to ensure that at least half of the light passes through the polarizer. As two linearly polarized light waves propagate through PM fiber 118, the polarization of each of the light waves is maintained. Fiber 118 is wrapped around a piezoelectric cylinder that stretches the fiber to affect a differential phase shift between the two linearly polarized waves. In the embodiment shown in Figure 1A, the PM fiber 118 is at least long enough to serve as a PM delay line 119 to ensure that the differential phase modulation between the light waves is not negated when the light waves return from the sense head assembly 124. The PM delay line 119 allows for AC biasing of the signal on the detector 130 and for phase sensitive detection.

The linearly polarized light then enters the sense head assembly 124. The sense head assembly 124 comprises a quarter wave device 120, a sensing coil 126, and a mirror 122. The quarter wave device 120 is a fiber with a known birefringence that induces an effective refractive index difference between linearly polarized light waves along two principal axes of the fiber. This birefringence is known as shape-induced-birefringence and is created by a difference along two principal axes of the shape of a core and cladding of the quarter wave device 120. The quarter wave device 120 thus has high birefringence that has two indices of refraction for the two polarization states, suitably differing in value, which affect the propagation of a light wave through the fiber. In one embodiment, the difference in index is approximately 0.1 % of index of refraction of the fiber. In one implementation, the average index of refraction of the fiber of the quarter wave device 120 is approximately 1.47.

The shape-induced-birefringence fiber causes one component of the light wave to propagate more slowly, corresponding to the higher refractive index, than the other component of the light wave, corresponding to the lower refractive index. For example, the speed of light in the fiber is slower in one direction than in an orthogonal direction, for example, along an x-axis and a y-axis, respectively. This difference in propagation speed is due to the shape or geometry of the fiber. Because the quarter wave device 120 has shape-induced-birefringence rather than stress induced birefringence, it is much more insensitive to temperature variation. In turn, the desired quarter wave of optical phase difference in quarter wave device 120 is very insensitive to temperature fluctuations.

With its polarization axes rotated at 45° to the linear polarization axes of PM fiber 118, the quarter wave device 120 converts one linearly polarized light wave from one axis of PM fiber 118 to one circularly polarized light wave, for example, right circularly polarized light. Similarly, the quarter wave device 120 also converts the other linearly polarized light wave from the other axis of PM fiber 118 to the orthogonally circularly polarized light wave, for example, left circularly polarized light. The now circularly polarized light waves travel along a forward path 128, passing through a sensing coil 126 wrapped around the current conductor 140. The circularly polarized light waves reflect off a mirror 122 where the originally right circularly polarized wave becomes left circularly polarized and the originally left circularly polarized wave becomes right circularly polarized. Each wave then propagates back through the sensing coil 126 following a reverse path 129, and the light re-travels part of the path from which it came.

A magnetic field is induced proportional to the electrical field generated when a current flows through the current conductor 140. Through the Faraday effect, the magnetic field affects the light propagating through the sensing coil 126. A phase shift will occur between the phases of the circularly polarized light waves as they travel through sensing coil 126 in the forward direction 128. The phase shift is doubled due to the light waves reflecting off mirror 122 and passing through sensing coil 126 in the reverse direction 129. The amount of phase shift between the circularly polarized light waves in forward path 128 and reverse path 129 is used to calculate the current flowing through the current conductor 140. The ratio of the phase shift to the current is determined by the number of turns of sensing coil 126 around the conductor 140 as well as by the Verdet constant of the material in the sensing coil 126. The Verdet constant describes the strength of the Faraday effect in a given material. In one implementation, the sensing coil 126 comprises fused silica.

Thus, to enable the measurement of a phase shift between light waves in forward path 128 and reverse path 129, the light is converted from a linear polarization state to a circular polarization state prior to entering sensing coil 126. The light is linearly polarized by polarizer 116 as discussed above. The propagation of the light through the shape-induced-birefringence quarter wave device 120 having a high birefringence ensures the polarization state of the light in the sensing coil 126 is circular.

The light retraces its path along reverse path 129 to the coupler 104. The coupler 104 directs at least part of the incoming beam towards detector 130. The detector 130 determines the phase difference in the light induced by the magnetic field of the current conductor 140 as the light traveled in sensing coil 126. In one embodiment, detector 130 comprises a photodiode, an amplifier, an A/D converter, and a phase sensitive digital demodulator that detects the phase shift. This phase shift is provided to the signal processing electronics 132, which uses the phase shift to calculate the current in the current conductor 140. In one embodiment, the signal processing electronics 132 comprises a field programmable gate array (FPGA), an application-specific integrated circuit (ASIC), or any other suitable processing circuitry.

Signal processing electronics 132 is also coupled to a temperature sensor 134 and a piezoelectric transducer 136. The piezoelectric transducer 136 stretches the PM fiber 118 to create a sinusoidally varying difference in path length between the two linear polarization states traveling in the PM fiber 118. In one implementation, a portion of the PM fiber 118 is wrapped around the piezoelectric transducer 136. The sinusoidally varying difference in path length induces a modulation between the two interfered light waves at detector 130, known as AC-biasing, so that the measurement of phase delay due to electric current is converted to a signal at the modulation frequency applied to the piezoelectric transducer 136. The signal processing electronics 132 generates the source of the modulation and provides a reference to demodulate the signal to a digital demodulator within the detector 130. In one embodiment, the interference signal at the detector 130 is biased to a sensitive setpoint such that small phase shifts due to electrical current flow are detected. The detector 130 is further sensitive to phase shifts when the input signal is an AC signal, thus having reduced low frequency 1/f noise. In another embodiment, the temperature sensor is used to compensate for the fact that the Verdet constant of the fiber within the sensing coil 126 is thermally sensitive. The signal processing electronics 132 corrects errors due to changes in temperature using the environmental temperature (for example, the outdoor temperature) and the Verdet constant change with temperature of the PM fiber 118.

In one embodiment, the optical fiber 110 is a single mode (SM) fiber and the cable assembly 112 is a rugged SM fiber cable. In another embodiment, polarization maintaining (PM) fiber 118 replaces cable 112 and fiber 110. In yet another embodiment, a second polarizer is situated near the end of the input path to ensure the light entering the quarter wave device 120 is linearly polarized. The techniques described herein can be used with other interferometry techniques and signal processing used in the art used to resolve the phase difference in the light.

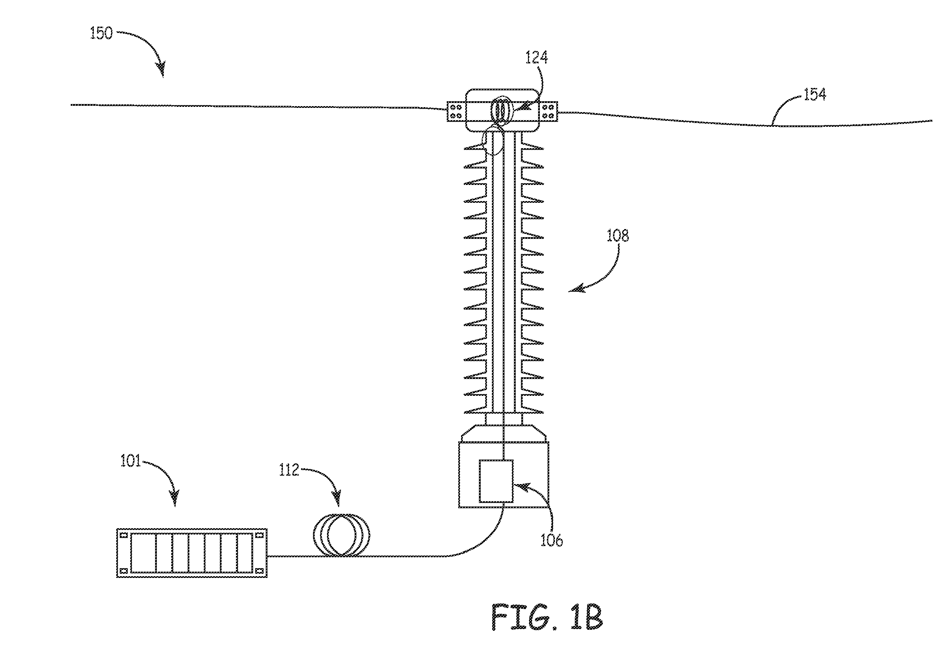

Figure 1B is a schematic diagram of an embodiment of a high voltage system 150. The high voltage system 150 determines the current flowing through a high voltage power line 154. The high voltage system 150 implements the fiber optic current sensor 100 shown in Figure 1A and comprises electronics and indoor optics 101, a cable assembly 112, an polarizing and modulation assembly 106, an insulator assembly 108, and a sensor head assembly 124. The electronics and indoor optics 101 generates light used to sense the current travelling in the high voltage system 150 and calculates the current from an induced phase shift in the light. The electronics and indoor optics 101 comprises, for example, the light source 102, coupler 104, detector 130, and signal processing electronics 132 of Figure 1A.

In the exemplary embodiment shown in Fig. 1B, the electronics and indoor optics 101 outputs non-polarized light that propagates through cable assembly 112 to the polarizing and modulation assembly 106. The polarizing and modulation assembly 106 converts the non-polarized light into linearly polarized light. This linearly polarized light travels through insulator assembly 108, which is an insulated column comprising PM fiber that maintains the linearly polarized light and shields it from environmental effects. The insulator assembly 108 raises the light from ground level to the sensor head assembly 124. In one embodiment, the sensor head assembly 124 is located proximate to the high voltage power line 154, for example, at the level that the high voltage power line 154 is strung.

The sensor head assembly 124 converts two linearly polarized light waves to circularly polarized light waves. The circularly polarized light waves are passed through a sensing coil wrapped around the high voltage power line 154 and reflected back. Two light waves, phase shifted with respect to each other, are passed back through the system 150, where it is diverted to detector 130 in the electronics and indoor optics 152. The signal processing electronics 132 calculates the current in the high voltage power line 154 from the phase shift. In one embodiment, the current sensor measures very accurately the current on high voltage line 154 which has insulation between ground potential and the high voltage line 154. An exemplary temperature range the current sensor is accurate over is -40 to 70 C°.

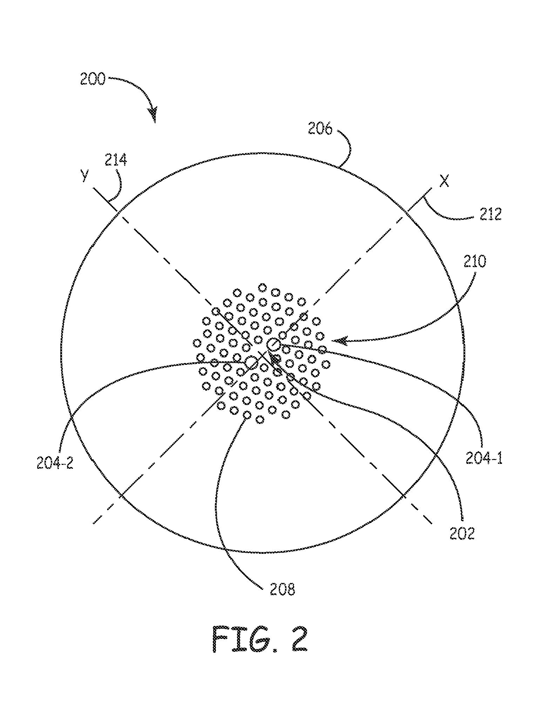

Figure 2 is a diagram of one embodiment of a shape-induced-birefringence fiber 200 (also referred to herein as fiber 200). The shape-induced-birefringence fiber 200 can be used as the quarter wave device 120 of Figure 1A. The fiber 200 has a difference in path length between polarization axes, x-axis 212 and y-axis 214, and the difference in propagation of light between the axes is due to the shape of the fiber 200. The fiber 200 has an asymmetry between the polarization axes 212 and 214. The birefringence of fiber 200 does not significantly change over temperature variation. In one embodiment, the thermal coefficient of birefringence of the fiber 200 is up to approximately 200 times less than conventional birefringence fibers or PM fibers.

The shape-induced-birefringence fiber 200 comprises a surrounding material 206 with a relatively high refractive index and a low refractive index region 208. In one embodiment, the surrounding material 206 is a solid glass region. The low refractive index region 210 comprises a solid glass center 202, two large hollow regions or holes 204-1 and 204-2 derived from hollow glass tubes proximate the glass center 202, a pattern of glass holes 208. The pattern of glass holes 208 comprise a structure derived from stacked glass-walled hollow tube capillaries comprising silica fibers together into a preform. A preform is used to draw an optical fiber and is typically made of glass. The surrounding material 206, derived from a solid glass tube in a preform stage, provides a solid glass region surrounding the low refractive index region 208. The aspect ratio of the two tubes that holes 204-1 and 204-2 are derived from is selected to adjust the path length difference between light polarized on axes 212 and 214, thus adjusting the degree of birefringence. The average index of refraction of the fiber medium is lower along the axis 212 following the two large holes 204-1 and 204-1 than it is along axis 214. Figure 2 is but one exemplary embodiment of a shape-induced-birefringence fiber 200, and any design employing more or less large holes 204-1 and 204-2 of any size and in any orientation is contemplated.

In the embodiment of Figure 2, the fiber 200 is a photonic crystal fiber. The photonic crystal fiber 200 provides a microstructured arrangement of material with a first refractive index in a surrounding material 206. The surrounding material 206 is, for example, glass or undoped silica. The low refractive index region 208 is typically provided by air voids running along the length of the fiber 200. In some embodiments, the fiber 200 is a solid core photonic bandgap fiber. In other embodiments, the fiber 200 is a hollow core photonic bandgap fiber.

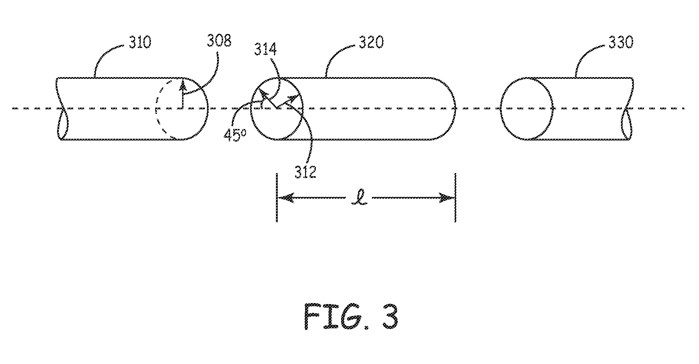

Figure 3 is an exemplary embodiment of a shape-induced-birefringence fiber 320 with its polarization axes 312, 314 rotated at 45 degrees to a polarization axis 308 of a polarization maintaining fiber 310. The shape-induced-birefringence fiber 320 is a quarter wave device, such as quarter wave device 120 of Figure 1A. The shape-induced-birefringence fiber 320 converts incoming linearly polarized light to circularly polarized light and outputs it to optical fiber 330. The fibers 310, 320, and 330 are joined using techniques known to one of skill in the art.

Linearly polarized light in the direction of axis 308 is delivered to the shape-induced-birefringence fiber 320 through the PM fiber 310. The linearly polarized light is converted to circularly polarized light when it transmits through a medium with polarization axes 312 and 314 that are at approximately 45° degrees to the polarization axis 308. This results in an equal amount of linearly polarized light hitting the axis 312, 314 since they are at a 45° degree orientation relative to the incoming light. As such, the linearly polarized light is projected onto the two axes 312 and 314 of the quarter wave device, which has a different path length for the light on axis 312 than axis 314. When the light is emitted from the shape-induced-birefringence fiber 320, the two light components are 90° out of phase, therefore producing circularly polarized light.

Different amounts of rotation between axis 308 and axes 312 and 314 results in different percentages of total circularly polarized light. The phase shift of the light induced by a magnetic field depends upon the percentage of the light that is circularly polarized. Linearly polarized light can undergo a state change in the presence of a magnetic field (for example, to be linearly polarized in a different orientation), but the state of circularly polarized light remains the same. De-phasing the two light components by an angle other than 90 degrees results in deviation from circular, with some linear and some circular, resulting in generally elliptical emitted light.

In one embodiment, the length, 1, of the shape-induced-birefringence fiber 320 is determined to be an odd positive integer multiple of one quarter beat length (1, 3, 5, 7, etc.). In one embodiment this is realized by the length being a non-zero integer multiple of a beat length plus or minus a quarter beat length of the fiber 320, or the length being just a quarter or three quarters of a beat length. Beat length is the length of a birefringence medium that results in the total path length along a first polarization axis to be one wavelength longer than the total path along the second polarization axis, referred to as a wavelength of retardation. For example, in a typical shape-induced-birefringence fiber, one millimeter corresponds to one wavelength of retardation. In general, the applications for the fiber are such that the goal is to minimize the length of the fiber to achieve a desired retardation. This corresponds to the difference between the indices of refraction being as large as possible. However, in one embodiment, the shape-induced-birefringence fiber 320 suitably has an increased beat length, 1, so that a fiber 320 is more manageable to manipulate. A fiber 320 that has one wavelength of retardation per four or five millimeters of fiber is much easier to manipulate than a fiber 320 that has one wavelength of retardation over one millimeter of fiber 320. A shape-induced-birefringence fiber 320 is suitably selected to be a length which is short enough to maintain its polarization-maintaining characteristics and long enough to make it practical to handle and cleave. In one embodiment, the size and location of the large holes 204-1 and 204-2 are modified to achieve a desired beat length 1.

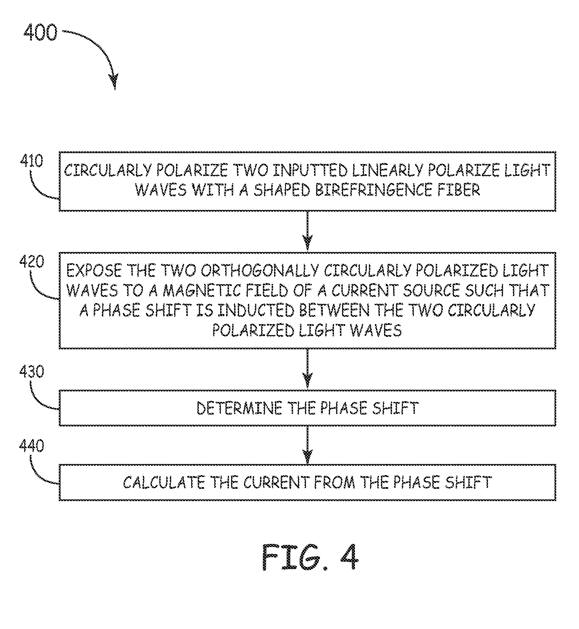

Figure 4 is a flowchart of a method 400 of sensing current using a current sensor with a shaped birefringence fiber. The method 400 begins at block 410 with using a shaped birefringence fiber to circularly polarize two inputted linearly polarized light wave. In one embodiment, there is approximately 45° between the axes of the PM fiber and the polarization axes of the shaped birefringence fiber. In one embodiment, the linearly polarized light is generated by passing light though a polarizer and propagating the linearly polarized light to the shaped birefringence fiber via a polarization maintaining fiber. In one embodiment, the light source is located, for example, in a controlled environment, far from the current conductor to be measured, for example, up to 100 m.

Once the light waves are circularly polarized, they are exposed to a magnetic field of a current source such that a phase shift is induced between the circularly polarized light at block 420. In one embodiment, the circularly polarized light waves travel from the shape-induced-birefringence quarter wave device 120 into a sensing coil 126 that is wrapped around current conductor 140. The circularly polarized light waves undergo a relative phase shift due to the current conductor's 140 induced magnetic field on a forward path 128 through the sensing coil 126. The amount of phase shift is doubled after the light is reflected off mirror 122 and travels back through the sensing coil 126. The light travels back through the shape-induced-birefringence quarter wave device 120 and through the linear polarizer 116, to ultimately be directed to a detector 130.

The detector 130 determines the phase shift that was induced in the light by the current conductor 120 at block 430. The detector 130 provides the phase shift to the signal processing electronics 132. The signal processing electronics 132, for example, calculates the current from the phase shift at block 440. This current will be accurate over a wide temperature range because the shape-induced-birefringence fiber maintains its performance as a quarter wave device 120 across the wide temperature range.

Embodiments described herein provide a shape-induced-birefringence fiber as a quarter wave device for a current sensor that is environmentally stable, lightweight, safe, easy to install, compatible with a digital interface, and accurate over a wide temperature range. Erroneous readings of currents in high voltage power lines over outdoor temperatures are reduced by reducing the thermal sensitivity of the element or elements, such as the quarter wave devices, that affect its accuracy. The embodiments of the current sensors described herein have simpler temperature compensated or less characterization for temperature, which saves cost.

A number of embodiments of the invention defined by the following claims have been described. Nevertheless, it will be understood that various modifications to the described embodiments may be made without departing from the spirit and scope of the claimed invention. Accordingly, other embodiments are within the scope of the following claims.

## Claims

1. A sensor head assembly (124), comprising
a quarter wave device (120) having shape-induced-birefringence;
a sensing coil (126) coupled to the quarter wave device and operable to wind around a current conductor (140); and
wherein the quarter wave device converts linearly polarized light from a polarization maintaining fiber (118) to circularly polarized light.

2. The sensor head assembly of claim 1, further comprising:
wherein a phase shift is induced in the circularly polarized light through exposure to a magnetic field of the current conductor in the sensing coil.

3. The sensor head assembly of claim 1, further comprising:
wherein a polarization axis (314) of the quarter wave device is tilted at approximately 45 degrees with respect to a principal polarization axis (308) of the polarization maintaining fiber.

4. The sensor head assembly of claim 1, further comprising:
wherein the quarter wave device has a length that is an odd integer multiple of a quarter beat length for the linearly polarized light.

5. The sensor head assembly of claim 1, wherein the quarter wave device is a photonic crystal fiber (200).

6. The sensor head assembly of claim 5, wherein the photonic crystal fiber comprises:
a surrounding material (206) of a first refractive index;
a low refractive index region (210) encompassed by the surrounding material, comprising:
a glass center (202);
a first and second hollow region (204-1 and 204-2) located proximate to the glass center along a first axis (212), wherein an average index of refraction of the low refractive index region is lower along the first axis than along a second axis (214) orthogonal to the first axis; and
a plurality of holes (208) formed in the low refractive index region around the glass center.

7. A current sensor (100), comprising:
a light source (102) coupled to a first end of an optical path;
a sensor head assembly (124) coupled to a second end of the optical path, comprising:
a shape-induced-birefringence fiber (120) coupled to a polarization maintaining fiber (118) located along the optical path between the first and second ends of the optical fiber; and
a sensing coil (126) coupled to the shape-induced-birefringence fiber, wherein circularly polarized light passing through the sensing coil undergoes a phase shift; and
a detector (130) coupled to a third end of the optical path, wherein the detector determines the value of the phase shift; and
signal processing electronics (132) coupled to the detector that resolves the phase shift into a current value.

8. The current sensor of claim 7, further comprising:
a polarizer (116) coupled to the polarization maintaining fiber that linearly polarizes light emitted from the light source; and
a mirror (122) affixed to the sensing coil, wherein the mirror reflects some of the light through a portion of the optical path to the third end.

9. The current sensor of claim 7, further comprising:
wherein the shape-induced-birefringence fiber has a first polarization axis (314) that is tilted at approximately 45 degrees with respect to the polarization of the linearly polarized light.

10. The current sensor of claim 7, further comprising:
a coupler (104) connected to the optical path between the light source and the detector, wherein the coupler diverts phase shifted light to the detector; and
a temperature sensor (134) coupled to the signal processing electronics.
